# EUROPÄISCHE PATENTSCHRIFT

(11) **EP 3 415 876 B1**
(45) Veröffentlichungstag und Bekanntmachung des Hinweises auf die Patenterteilung: **09.06.2021**
(21) Anmeldenummer: 18177334.2
(22) Anmeldetag: 11.02.2015
(51) Int. Cl.: G01F 1/716, G01F 1/74

(54) **VERFAHREN ZUM BETREIBEN EINES KERNMAGNETISCHEN DURCHFLUSSMESSGERÄTES**
METHOD FOR OPERATING A NUCLEAR MAGNETIC FLOW METER
PROCÉDÉ DE FONCTIONNEMENT D'UN DÉBITMÈTRE NUCLÉAIRE MAGNÉTIQUE

(30) Priorität: 10.07.2014 DE 102014010237; 30.10.2014 DE 102014015943
(43) Veröffentlichungstag der Anmeldung: 19.12.2018
(62) Teilanmeldung aus: 15000398.6
(73) Patentinhaber: Krohne AG, 4019 Basel (CH)
(72) Erfinder: Hogendoorn, Cornelis Johannes, 4211 BG Spijk (NL); Bousché, Olaf Jean Paul, 3319 PH Dordrecht (NL); Zoeteweij, Marco Leendert, 3344 EP Hendrik-Ido-Ambach (NL); Cerioni, Lucas Matias Ceferino, 3311 GN Dordrecht (NL); Tromp, Rutger Reinout, 3311 EM Dordrecht (NL)
(74) Vertreter: Gesthuysen Patentanwälte

(56) Entgegenhaltungen:
- EP-A2- 0 510 774
- WO-A2-98/59220
- WO-A2-2004/099817
- US-A- 4 769 602
- US-A1- 2006 020 403
- US-A1- 2012 209 541

## Beschreibung

Die Erfindung betrifft ein Verfahren zum Betreiben eines kernmagnetischen Durchflussmessgerätes zur Bestimmung des Durchflusses eines mit Schwallströmung durch ein Messrohr strömenden Mediums, das eine geringe oder keine Salinität aufweist, mit einer Messeinrichtung, wobei die Messeinrichtung einen RF-Kreis mit einer externen Elektronik und mit mindestens einer zum Erzeugen von das Medium anregenden Anregungssignalen und/oder zur Detektion von vom Medium ausgesandten Messsignalen ausgestalteten RF-Spule umfasst.

Kernmagnetische Durchflussmessgeräte sind zur Bestimmung des Durchflusses eines durch ein Messrohr strömenden Mediums ausgebildet. Das Medium kann eine Phase oder mehrere Phasen beinhalten. Bei einem einphasigen Medium erfolgt die Bestimmung des Durchflusses durch die Bestimmung der Strömungsgeschwindigkeit des Mediums. Die Bestimmung des Durchflusses eines mehrphasigen Mediums umfasst neben der Bestimmung der Strömungsgeschwindigkeit ebenfalls die Bestimmung der Anteile der einzelnen Phasen an dem Medium.

Grundvoraussetzung für die Anwendbarkeit kernmagnetischer Messmethoden ist, dass das Medium oder jede Phase des Mediums Atomkerne mit magnetischen Momenten aufweist. Zur Unterscheidung der einzelnen Phasen ist es zudem nötig, dass die Phasen unterscheidbare Relaxationszeiten besitzen.

Das aus Ölquellen geförderte mehrphasige Medium besteht, wie in der US 2006/020403 A1 offenbart ist, im Wesentlichen aus den beiden flüssigen Phasen Rohöl und Salzwasser und der gasförmigen Phase Erdgas, wobei alle drei Phasen Wasserstoffkerne enthalten, die ein magnetisches Moment tragen.

Das durch das Messrohr des Durchflussmessgerätes strömende Medium kann verschiedene Strömungscharakteristiken aufweisen. Das bedeutet, dass die einzelnen Phasen des Mediums über ein Volumenelement gesehen verschieden verteilt sein können. Eine häufig auftretende Strömung bei aus Ölquellen geförderten Medien ist die Schwallströmung. Die Schwallströmung weist eine sehr komplexe Charakteristik auf und ist im Wesentlichen durch eine ständige Unterbrechung einer gleichmäßigen Strömung gekennzeichnet. Eine Schwallströmung kann in zwei Bereiche aufgeteilt werden, die abwechselnd auftreten. Der erste Bereich ist durch einen Schwall an flüssigem Medium gekennzeichnet, wobei das flüssige Medium den gesamten Messrohrquerschnitt ausfüllt. In dem flüssigen Medium sind kleine Gasblasen unregelmäßig verstreut. Dieser Bereich wird als Schwallbereich bezeichnet. Der zweite Bereich besteht aus einer großen Gasblase, die einen dominierenden Teil des Messrohrquerschnitts einnimmt, und einem Flüssigkeitsfilm, der den verbleibenden Bereich des Messrohrquerschnitts ausfüllt. Dieser Bereich wird als Filmbereich bezeichnet. Die Ausdehnungen der beiden abwechselnden Bereiche sind beliebig und unregelmäßig.

Kernmagnetische Durchflussmessungen sind dadurch charakterisiert, dass ein das Medium anregender Anregungspuls in einer externen Elektronik erzeugt wird, der Anregungspuls durch eine RF-Spule in das Medium eingespeist wird, und mit einer RF-Spule die Antwort des angeregten Mediums detektiert wird und zur Verarbeitung ebenfalls an eine externe Elektronik übertragen wird. Ein kernmagnetisches Durchflussmessgerät umfasst also zumindest eine externe Elektronik und eine vom Medium durchströmte RF-Spule, die zusammen einen RF-Schwingkreis bilden. Das die RF-Spule durchströmende Medium muss hierbei als eine zusätzliche Last in dem RF-Schwingkreis betrachtet werden.

Durch das sogenannte "tuning" wird die Frequenz des RF-Kreises so eingestellt, dass Resonanz erreicht wird, also das maximal mögliche Signal.

Um eine maximale Leistungsübertragung zwischen externer Elektronik und RF-Spule zu garantieren, muss die Impedanz der Spule der externen Elektronik angepasst werden. Dieser Vorgang wird als "Anpassen" oder "matching" bezeichnet. Ein falsches bzw. ungenaues "matching", führt dazu, dass die Leistung nicht vollständig übertragen, sondern teilweise reflektiert wird. Wird Leistung reflektiert, wird nicht genug Leistung in die Spule gegeben. Das führt dazu, dass das von der RF-Spule erzeugte Magnetfeld B₁ nicht die vorgesehene Stärke aufweist und demnach die Magnetisierung des Mediums um einen kleineren Wert als den vorgesehenen Wert ausgelenkt wird.

Ein unzureichendes "matching" führt zudem auch bei der Detektion der von der Probe ausgesendeten Messsignale zu Schwierigkeiten. Das von der Probe ausgesendete Messsignal, das meist sehr klein ist, "wirkt" bei falschem "matching" noch schwächer, was auch zu einem sehr schlechten Signal-RauschVerhältnis führt.

Vor einer jeden kernmagnetischen Durchflussmessung müssen, um optimale Messbedingungen zu garantieren, das "tuning" und "matching" eingestellt werden.

Wie bereits ausgeführt, sind die Einstellungen für das "matching" von der Impedanz der RF-Spule abhängig. Bei dem Wert für die Impedanz der RF-Spule wird die zusätzliche, durch das Medium auftretende Last berücksichtigt. Die Last des Mediums hängt von der Charakteristik des Mediums ab. Strömt ein eine Schwallströmung aufweisendes Medium durch das Messrohr, ist die zusätzliche Last in dem RF-Schwingkreis eine andere, wenn sich gerade ein Schwallbereich in der RF-Spule befindet, als wenn sich ein Filmbereich in der Spule befindet.

Demnach müssten je nach Bereich die Einstellungen für das Matching korrigiert werden, was praktisch nicht möglich oder sehr aufwendig ist.

Aus der Praxis ist bekannt, aufwendige Datenanalysealgorithmen bei der Datenauswertung zu verwenden, die zwischen den beiden Bereichen unterscheiden können. Diese Algorithmen sind jedoch sehr aufwendig, wodurch die Datenauswertung sehr zeitaufwendig und zudem auch fehlerbehaftet wird.

Aufgabe der Erfindung ist die Angabe eines Verfahrens zum Betreiben eines kernmagnetischen Durchflussmessgerätes, bei dem die aus dem Stand der Technik bekannten Nachteile minimiert und die Datenhandhabung vereinfacht wird.

Zunächst wird davon ausgegangen, dass das Medium einen hohen Salzgehalt aufweist, insbesondere das Salzwasser einen hohen Salzgehalt aufweist und/oder der Salzwasseranteil im Medium hoch ist.

Dann ist die zuvor hergeleitete und aufgezeigte Aufgabe dadurch gelöst, dass die "tuning"- Parameter und die "matching"-Parameter für einen Schwallbereich und für einen Filmbereich bestimmt werden, dass die Parameter für einen Schwallbereich eingestellt werden oder dass die Parameter für einen Filmbereich eingestellt werden, dass über eine Zeit t die reflektierte Leistung gemessen wird, wobei die reflektierte Leistung bei einem für Schwallbereich eingestellten System niedrig ist für den Schwallbereich und hoch ist für den Filmbereich und wobei die Leistung bei einem für Filmbereich eingestellten System niedrig ist für den Filmbereich und hoch ist für den Schwallbereich, dass anhand der reflektierten Leistung die relativen Verweilzeiten der Schwallbereiche und Filmbereiche in der RF-Spule sowie die relativen Häufigkeiten der Schwallbereiche und Filmbereiche im strömenden Medium bestimmt werden und dass der Sprung in dem Wert der reflektierten Leistung von einem hohen Wert zu einem niedrigen Wert als Auslöser zum Starten einer Messung genutzt wird. Diese Lösung ist zwar nicht Gegenstand der vorliegenden Erfindung, soll jedoch im Folgdenden erläutert werden, um Kontext für die Erfindung zu schaffen.

Das Verfahren eignet sich in besonderer Weise zum Vermessen von Medien mit hohem Salzgehalt, insbesondere von Medien mit einem großen Anteil an Salzwasser, das einen hohen Salzgehalt aufweist. Insbesondere bei sehr salzhaltigen Medien unterscheiden sich die auftretenden Lasten bei hohem und niedrigem Flüssigkeits-Volumen-Verhältnis im RF-Kreis in einem großen Maße, so dass verschiedene Messmodi zur Vermessung der verschiedenen Bereiche unabdingbar sind, wenn auf eine aufwendige Datenanalyse verzichtet werden soll.

Um ein Durchflussmessgerät zu kalibrieren, also um die "tuning"-Parameter und die "matching"-Parameter für die jeweiligen Bereiche, also den Schwallbereich und den Filmbereich, zu bestimmen, kann während der Kalibration eine die Variationen der "tuning"-Parameter und der "matching"-Parameter beschreibende Kurve aufgenommen werden. Anhand der Kurve kann dann ein Wert für die jeweiligen Parameter sowohl im Schwallbereich als auch im Filmbereich bestimmt werden.

Ein niedriger Wert der reflektierten Leistung bedeutet, dass die Parameter für das "matching" gut sind, die Leistung also von der externen Elektronik auf die RF-Spule (fast) vollständig übertragen wird, wohingegen bei einem schlechten "matching" die reflektierte Leistung hoch ist. Sind die Parameter für einen bestimmten Bereich eingestellt, kann anhand der reflektierten Leistung bestimmt werden, ob sich gerade der Bereich, auf den die Parameter abgestimmt sind, oder der andere Bereich in der RF-Spule befindet. Hierbei muss die reflektierte Leistung in einer guten zeitlichen Auflösung gemessen werden, also hinreichend kleine Zeitintervalle zwischen den einzelnen Messungen gewählt werden. Durch die Erhöhung der zeitlichen Auflösung der Messungen erhöht sich die Genauigkeit der Detektion der Schwallbereiche und der Filmbereiche in dem Medium. Die RF-Leistung, bei der die Reflexionsmessungen durchgeführt werden, sollte ausreichend klein gewählt werden, um zu vermeiden, dass das sich in der RF-Spule befindliche Medium gestört wird. Zu beachten ist jedoch auch, dass relativ lange RF-Pulse notwendig sind, um ein stabiles Auslesen der reflektierten Leistung zu ermöglichen.

Durch das Verfahren wird garantiert, dass die Messungen mit auf die jeweilige Last des Mediums - abhängig von dem sich in der RF-Spule befindlichen Bereich des Mediums - abgestimmten Parametern durchgeführt werden, also dass ein Schwallbereich mit Schwallbereich-Einstellungen und ein Filmbereich mit Filmbereich-Einstellungen gemessen wird. Zur Datenanalyse kann auf einen aufwendigen Dateninterpretationsalgorithmus, der zwischen den beiden Durchflusssituationen unterscheiden kann, verzichtet werden.

Eine besondere Ausführungsform des Verfahrens ist dadurch gekennzeichnet, dass die Messung, die durch den Sprung von einem hohen zu einem niedrigen Wert der reflektierten Leistung gestartet wird, eine Messung zur Optimierung der "tuning"-Parameter und der "matching"-Parameter ist, dass startend von den Anfangsparametern weitere Punkte im "tuning"-und-"matching"-Parameterraum vermessen werden, wobei die Anzahl der Messpunkte auf der bekannten minimalen Schwallverweilzeit und der Zeit, die ein einzelner "tuning"-und-"matching"-Messpunkt benötigt, basiert, dass nach der Aufnahme der Messpunkte die Anfangsparameter wieder eingestellt werden und überprüft wird, ob die reflektierte Leistung noch einen niedrigen Wert hat und dass ein Teil der aufgenommenen Messpunkte verworfen wird oder alle aufgenommenen Messpunkte verworfen werden, wenn die reflektierte Leistung bei der Überprüfung einen hohen Wert hat.

Durch diese Ausgestaltung des Verfahrens können die "tuning"-Einstellungen und die "matching"-Einstellungen sowohl für den Schwallbereich als auch für den Filmbereich optimiert werden.

Eine weitere Ausgestaltung des Verfahrens ist dadurch gekennzeichnet, dass die Messung, deren Start durch den Sprung der gemessenen Leistung von einem hohen zu einem niedrigen Wert ausgelöst wird, eine kernmagnetische Messung ist.

Das Verfahren bietet die Möglichkeit, die Daten der reflektierten Leistung zu nutzen, um einzelne Datenpunkte bzw. Messpunkte aus einer einzelnen kernmagnetischen Messung zu akzeptieren oder zu verwerfen. Insbesondere können die Daten der kernmagnetischen Messung verworfen werden, die zum Zeitpunkt eines Sprungs in der reflektierten Leistung aufgenommen wurden. Eine Messung während eines Sprungs tritt vor allem dann auf, wenn eine kernmagnetische Messung über einen längeren Zeitraum erfolgt, als die Aufenthaltsdauer des entsprechenden Bereichs in der RF-Spule ist. Ist die Messdauer größer als die Aufenthaltsdauer, werden die Messungen am "Ende" der Messung mit "falschen" Einstellungen durchgeführt. Insbesondere ist dann auch vorgesehen, die Datenpunkte bzw. Messpunkte mit den "falschen" Einstellungen zu erkennen und zu verwerfen. Hierdurch sinken erneut die Anforderungen an die bei der Datenauswertung verwendeten Dateninterpretationsalgorithmen und der bei der Datenauswertung betriebene Aufwand wird deutlich reduziert.

Eine Ausgestaltung des Verfahrens ist dadurch gekennzeichnet, dass die Parameter für den Schwallbereich des Mediums eingestellt werden. Die kernmagnetische Messung ist durch eine CPMG-Sequenz realisiert, wobei bei der kernmagnetischen Messung die Methode der Vormagnetisierungskontrastmessung genutzt wird. Vorzugsweise ist vorgesehen, dass mit den durch die kernmagnetische Messung gewonnenen Daten die Strömungsgeschwindigkeit des Mediums und mit Hilfe der Signal-Amplituden-Daten das Wasser-Flüssigkeits-Verhältnis bestimmt werden.

Das Verfahren ist jedoch nicht auf die Verwendung einer CPMG-Sequenz beschränkt, vielmehr ist jede Pulssequenz, die zur Messung kernmagnetischer Eigenschaften verwendet wird, denkbar.

Auch kann es sich empfehlen, die Parameter für den Schwallbereich einzustellen und die kernmagnetische Messung durch Tomographie zu realisieren. Bei der Tomographie kann insbesondere eine Schichtung in z-Richtung vorgesehen werden. Zur Definition der Richtungen wird ein kartesisches Koordinatensystem zugrunde gelegt, wobei die x-Achse entlang der Strömungsrichtung liegt und die x-Achse mit der y-Achse eine waagerechte Ebene aufspannen. Die z-Achse steht demnach senkrecht auf der waagerechten Ebene. Mit den gemessenen Signalamplituden wird der Gasanteil, also der Gas-Volumen-Anteil im Schwallbereich bestimmt. Ebenfalls kann die Strömungsgeschwindigkeitsverteilung in dem Schwallbereich bestimmt werden.

Da der Gas-Volumen-Anteil auf Grundlage der Signalamplituden bestimmt wird, ist es unabdingbar, dass die richtigen Parameter eingestellt sind, also die Parameter für den entsprechenden Bereich des Mediums. Falsche Parameter führen zu nicht eindeutigen Signalamplituden, wodurch die Messungen nicht brauchbar sind.

Zwar ist eine Bestimmung der Signalamplituden und damit des Gas-Volumen-Anteils bei Messungen mit nicht auf den Bereich abgestimmten Parametern nicht möglich, jedoch ist bei einer Ausgestaltung des Verfahrens vorgesehen, dass eine kernmagnetische Messung mit Schwallbereich-Einstellung in dem Filmbereich durchgeführt wird. Aus den gemessenen Werten kann dann die Strömungsgeschwindigkeit des Mediums im Filmbereich bestimmt werden. Die Bestimmung der Durchflussraten erfolgt mit den aus den Messungen bestimmten Werten für die Strömungsgeschwindigkeit und mit vorher bestimmten Werten für das Wasser-Flüssigkeits-Verhältnis.

Bisher beschrieben sind besondere Ausgestaltungen des Verfahrens, bei dem die "tuning"-Parameter und die "matching"-Parameter für einen Schwallbereich abgestimmt wurden. Es sind auch Ausführungsformen möglich, die auf der Grundlage von auf einen Filmbereich abgestimmten "tuning"-Parametern und-" matching"-Parametern basieren.

Eine weitere Ausgestaltung des Verfahrens sieht vor, dass die "matching"-Parameter für den Filmbereich eingestellt werden und die kernmagnetische Messung mit einer CPMG-Sequenz realisiert wird. Da nach dem Verfahren die kernmagnetische Messung nach dem Sprung der Messwerte für die Leistung von einem hohen zu einem niedrigen Wert erfolgt, und - wie bereits ausgeführt - ein niedriger Wert ein gutes matching bedeutet, kann mit dieser Ausführungsform des Verfahrens der Filmbereich des Mediums charakterisiert werden. Vorzugsweise wird die Methode der Vormagnetisierungskontrastmessung genutzt und mit den Messdaten die Strömungsgeschwindigkeit des Mediums und mit Hilfe der Signal-Amplituden-Daten das Wasser-Flüssigkeits-Verhältnis im Filmbereich bestimmt.

Das Verfahren ist jedoch nicht auf die Verwendung einer CPMG-Sequenz beschränkt, vielmehr ist jede zur Bestimmung kernmagnetischer Eigenschaften denkbare Pulssequenz anwendbar.

Eine weitere Ausgestaltung des Verfahrens ist dadurch gekennzeichnet, dass mit den "matching"-Parametern für den Filmbereich die kernmagnetische Messung mit Tomographie mit Schichtung in z-Richtung ausgeführt wird. Mit den gemessenen Signalamplituden wird der Gasanteil (Gas-Volumen-Anteil) in dem Filmbereich bestimmt. Ebenfalls ist vorgesehen, dass mit den Messdaten das Flüssigkeitslevel im Messrohr bestimmt wird.

Wie bereits ausgeführt, ist zur eindeutigen Bestimmung der Signalamplituden, und damit zur Bestimmung des Gas-Volumen-Anteils in einem bestimmten Bereich des Mediums, unabdingbar, dass die "matching"-Parameter auf den entsprechenden Bereich abgestimmt sind.

Eine Ausgestaltung des Verfahrens ist dadurch gekennzeichnet, dass eine kernmagnetische Messung mit Filmbereich-Parametern in dem Schwallbereich durchgeführt wird. Aus den gemessenen Werten kann dann die Strömungsgeschwindigkeit des Mediums im Schwallbereich bestimmt werden. Die Bestimmung der Durchflussraten erfolgt mit den aus den Messungen bestimmten Werten für die Strömungsgeschwindigkeit und mit vorher bestimmten Werten für das Wasser-Flüssigkeits-Verhältnis.

Eine weitere Ausgestaltung sieht vor, die kernmagnetische Messung durch Tomographie mit Schichtung in z-Richtung realisiert wird und dass die kernmagnetische Messung über einen Zeitraum erfolgt, der mindestens einen Schwallbereich und einen Filmbereich erfasst. Hierbei können die "matching"-Parameter den Parametern des Schwallbereichs entsprechen, ebenfalls kann aber auch vorgesehen sein, dass die Parameter den Parametern des Filmbereichs entsprechen. Demnach gibt es in jedem Fall Bereiche hoher und niedriger reflektierter Leistung. Vorzugsweise ist nun vorgesehen, dass mit den aus der Tomographie gewonnenen Daten die Strömungsgeschwindigkeiten für jeden Zeitpunkt der Messung bestimmt werden und dass anhand der Daten der reflektierten Leistung die Strömungsgeschwindigkeiten einem Bereich zugeordnet werden können.

Bisher ist davon ausgegangen worden, dass das Medium einen hohen Salzgehalt aufweist, insbesondere das Salzwasser einen hohen Salzgehalt aufweist und/oder der Salzwasseranteil im Medium hoch ist. Jedoch ist ebenfalls denkbar, dass der Salzwasseranteil am Medium gering ist oder dass der Salzgehalt in dem Salzwasser gering ist oder gegen null geht.

Wie ausgeführt, ist die durch das strömende Medium bedingte zusätzliche Last in dem RF-Schwingkreis abhängig zum einen von dem sich in der RF-Spule befindlichen Bereich und zum anderen von der Salinität des Mediums. Demnach ist auch der Betrag der reflektierten Leistung abhängig von der Salinität des Mediums. Weist das Medium einen geringen oder keinen Salzgehalt auf, ist die Last in dem RF-Kreis näherungsweise identisch für den Schwallbereich und den Filmbereich, so dass die "tuning"-Parameter und die "matching"-Parameter für beide Bereiche gleich sind. Eine Unterscheidung der Bereiche auf Grundlage der reflektierten Leistung, wie oben beschrieben, ist demnach nicht möglich.

Im Rahmen der Erfindung kann statt auf Grundlage der reflektierten Leistung auf Grundlage der Signalamplituden zwischen dem Schwallbereich und dem Filmbereich bei einem Medium mit Schwallströmung unterschieden werden.

Insoweit ist die Erfindung dadurch gekennzeichnet, dass die "tuning"-Parameter und "matching"-Parameter für einen Schwallbereich oder für einen Filmbereich eingestellt werden, dass eine kernmagnetische Messung durchgeführt wird, dass anhand von gemessenen Signal-Amplituden bestimmt wird, ob sich ein Schwallbereich oder ein Filmbereich in der RF-Spule befindet und dass mit den Signal-Amplituden das Wasser-Flüssigkeits-Verhältnis und/oder der Gas-Volumen-Anteil im Schwallbereich und im Filmbereich bestimmt werden.

Für die kernmagnetische Messung kann eine CPMG-Sequenz oder eine andere zur Vermessung kernmagnetischer Größen übliche Pulssequenz verwendet werden. Ebenfalls ist es denkbar, dass die kernmagnetische Messung durch Tomographie mit Schichtung in z-Richtung realisiert wird.

In der Kernspintomographie sind verschiedene Ordnungsschemata bekannt, nach denen die Daten - insbesondere im Fourierraum - erfasst werden können.

Insbesondere bei der Anwendung der Kernspintomographie im Bereich der Durchflussmessung von strömenden Medien, die keine gleichmäßige, insbesondere keine stationäre Strömungscharakteristik aufweisen, ergeben sich besondere Anforderungen. So eignen sich einige Pulssequenzen besonders für eine hohe zeitliche Auflösung, jedoch ist hierfür eine sehr hohe Homogenität des extern angelegten Magnetfeldes unabdingbar. Pulssequenzen, die unempfindlicher gegenüber Feldinhomogenitäten sind, erzielen keine derart hohe zeitliche Auflösung.

Vorzugsweise wird im Rahmen des erfindungsgemäßen Verfahrens zur Datenerfassung das Ordnungsschema nach dem Goldenen Schnitt angewendet. Diese Methode ist ursprünglich aus dem Bereich der medizinischen Bildgebung bekannt, insbesondere wird sie bei Untersuchungen des Herzens oder der Lunge angewendet.

Das Ordnungsschema basierend auf dem Goldenen Schnitt gibt ein Schema an, nach dem Datenprofile im reziproken Raum aufgenommen werden. Es garantiert eine nahezu gleichmäßige Verteilung der Datenprofile für eine beliebige Anzahl an Datenprofilen. Das Schema sieht vor, Datenprofile in einer azimuthalen Schrittweite von 111,25° aufzunehmen, dem Goldenen Schnitt von 180°. Dadurch sind die radialen Linien mir der Zeit sehr gleichmäßig über den Raum verteilt. Dadurch wird garantiert, dass unabhängig von der Anzahl der für die Bildrekonstruktion genutzten Profile - insbesondere aber wenn die Anzahl der für die Bildrekonstruktion genutzten Profile einer Fibonacci-Zahl entspricht - die Profile gleichmäßig verteilt sind. Dadurch ergeben sich einige Vorteile, die insbesondere bei der Durchflussmessung eines eine Schwallströmungscharakteristik aufweisenden Mediums von Relevanz sind. Dadurch ist die Anzahl der für die Bildrekonstruktion genutzten Profile beliebig wählbar. Ist eine schnelle zeitliche Auflösung erforderlich, können wenige Profile gewählt werden, bei einer hohen räumlichen Auflösung hingegen kann die Datenrekonstruktion anhand einer Mehrzahl von Profilen erfolgen. Dieses Verfahren bietet den großen Vorteil gegenüber bisher verwendeten Verfahren in der Durchflussmesstechnik, dass die Bildrekonstruktion spontan variabel an die herrschenden Bedingungen angepasst werden kann und nicht vor der Messung bereits konkretisiert werden muss. So kann die Länge des Messfensters beliebig gewählt werden. Durch das Ordnungsschema nach dem Goldenen Schnitt ist zu jedem Zeitpunkt eine gleichmäßige Verteilung der Daten im Fourierraum gewährleistet. Dadurch ist es nicht mehr nötig, die für eine Messung benötigte zeitliche Auflösung oder Bilderneuerungsrate im Vorhinein festzulegen. Vielmehr kann die Anzahl der an der Datenrekonstruktion beteiligten Profile im Nachhinein angepasst werden, um situationsangepasst immer wieder erneut einen Kompromiss aus Bildqualität und zeitlicher Auflösung schließen zu können. Beispielsweise kann die Anzahl der Profile der Länge der Schwallbereiche und der Filmbereiche angepasst werden.

Da jedes Profil jeweils durch den Ursprung des reziproken Raumes führt, wird in jedem Profil die absolute Signalamplitude erfasst. Mit der Signalamplitude kann erkannt werden, ob es sich um einen Schwallbereich oder einen Filmbereich handelt.

Ebenfalls denkbar ist, die Position der Datenerfassungsfenster beliebig zu halten. Aufeinanderfolgende Profile werden grob über den gesamten reziproken Raum verteilt. Dadurch wird eine nahezu gleichförmige Profilverteilung über den gesamten reziproken Raum garantiert, unabhängig davon, wann die Datenaufnahme begonnen hat. Die Daten können dann den spezifischen Intervallen angepasst werden.

Es kann auch vorgesehen sein, mehrere Datenerfassungsfenster miteinander zu verschmelzen. Die Flexibilität in der Datenaufnahme erlaubt es, mehrere Datenerfassungsfenster, die während unterschiedlicher Intervalle, aber in dem gleichen Bereich aufgenommen wurden, zu vereinen. So kann zum Beispiel vorgesehen sein, Daten aus einem ersten Schwallbereich mit Daten aus einem zweiten Schwallbereich zu kombinieren, wodurch die Auflösung des kombinierten Bildes verbessert wird.

Eine weitere besondere Ausfuhrungsform des erfindungsgemäßen Verfahrens ist dadurch gekennzeichnet, dass zur Datenerfassung ein Ordnungsschema basierend auf Quasi-Randomisierung angewendet wird. Solche auf Quasi-Randomisierung oder Subrandomisierung basierenden Ordnungsschemata garantieren ebenfalls eine nahezu gleichmäßige Verteilung der Datenprofile für eine beliebige Anzahl von für die Datenaufnahme verwendeten Datenprofilen. Ordnungsschemata diesen Typs basieren auf Sequenzen mit niedriger Abweichung. Sequenzen niedriger Abweichung werden auch als Quasi-Zufalls-sequenzen bezeichnet. Im Gegensatz zu rein vorherbestimmten Sequenzen bieten die Quasi-Zufallssequenzen den Vorteil, dass sie trotz nicht vorbestimmter Datenprofilanzahl eine gleichmäßige Verteilung ermöglichen, demnach also die Anzahl der Datenprofile auch nachträglich an die herrschenden Bedingungen bei der Durchflussmessung angepasst werden kann. Insbesondere eignen sich für die Datenerfassung sehr gut die Halton-Sequenz, die van der Corput-Sequenz und die Faure-Sequenz.

## Patentansprüche

1. Verfahren zum Betreiben eines kernmagnetischen Durchflussmessgerätes zur Bestimmung des Durchflusses eines durch ein Messrohr mit Schwallströmung strömenden Mediums, das eine geringe oder keine Salinität aufweist, mit einer Messeinrichtung,
wobei die Messeinrichtung einen RF-Kreis mit einer externen Elektronik und mit mindestens einer zum Erzeugen von das Medium anregenden Anregungssignalen und/oder zur Detektion von vom Medium ausgesandten Messsignalen ausgestalteten RF-Spule umfasst,
wobei ein Schwallbereich der Schwallströmung durch einen Schwall an flüssigem Medium gekennzeichnet ist und das flüssige Medium den gesamten Messrohrquerschnitt ausfüllt und ein Filmbereich der Schwallströmung aus einer einen dominierenden Teil des Messrohrquerschnitts einnehmenden gro-βen Gasblase und einem den verbleibenden Messrohrquerschnitt ausfüllenden Flüssigkeitsfilm besteht,
wobei "tuning"-Parameter und "matching"-Parameter für einen Schwallbereich oder für einen Filmbereich eingestellt werden, wobei durch "tuning" die Frequenz des RF-Kreises so einstellbar ist, dass Resonanz erreicht wird, und durch "matching" die Impedanz der RF-Spule der der externen Elektronik anpassbar ist,
wobei eine kernmagnetische Messung durchgeführt wird,
wobei anhand von gemessenen Signal-Amplituden bestimmt wird, ob sich ein Schwallbereich oder ein Filmbereich in der RF-Spule befindet und
wobei mit den Signal-Amplituden das Wasser-Flüssigkeits-Verhältnis und/oder der Gas-Volumen-Anteil im Schwallbereich und im Filmbereich bestimmt werden.

2. Verfahren nach Anspruch 1, **dadurch gekennzeichnet, dass** für die kernmagnetische Messung eine CPMG-Sequenz oder einer anderen Pulssequenz zur Bestimmung kernmagnetischer Größen verwendet wird.

3. Verfahren nach Anspruch 1 oder 2, **dadurch gekennzeichnet, dass** die kernmagnetische Messung durch Tomographie mit Schichtung in z-Richtung senkrecht zur Strömungsrichtung realisiert wird.

4. Verfahren nach einem der Ansprüche 1 bis 3, **dadurch gekennzeichnet, dass** zur Datenerfassung das Ordnungsschema nach dem Goldenen Schnitt angewendet wird.

5. Verfahren nach einem der Ansprüche 1 bis 3, **dadurch gekennzeichnet, dass** zur Datenerfassung ein Ordnungsschema basierend auf Quasi-Randomisierung angewendet wird, insbesondere eine Halton-Sequenz, eine van der Corput-Sequenz oder eine Faure-Sequenz angewendet wird.

## Claims

1. Method for operating a nuclear magnetic flowmeter for determining the flow of a medium, which has low or no salinity, with slug flow flowing through a measuring tube, having a measuring device,
wherein the measuring device contains an RF circuit having external electronics and having at least one RF coil designed for generating an excitation signal for exciting the medium and/or for detecting measuring signals emitted by the medium,
wherein a slug zone of the slug flow is **characterized by** a surge of liquid medium and the liquid medium fills the entire cross section of the measuring tube and a film zone of the slug flow consists of a large gas bubble taking up a dominating portion of the cross section of the measuring tube and a liquid film filling the remaining cross section of the measuring tube,
wherein the "tuning" parameters and "matching" parameters are set for a slug zone or for a film zone, wherein the frequency of the RF circuit can be set with "tuning" so that resonance is achieved and the impedance of the RF coil can be adapted to that of the external electronics by "matching",
wherein a nuclear magnetic measurement is carried out,
wherein, using measured signal amplitudes, it is determined whether a slug zone or a film zone is present in the RF coil and
wherein the water-liquid ratio and/or the gas volume portion in the slug zone and the film zone are determined using the signal amplitudes.

2. Method according to claim 1, **characterized in that** a CPMG sequence or other pulse sequence is used for the nuclear magnetic measurement for determining nuclear magnetic variables.

3. Method according to claim 1 or 2, **characterized in that** the nuclear magnetic measurement is implemented using tomography with slicing in the z-direction perpendicular to the direction of flow.

4. Method according to any one of claims 1 to 3, **characterized in that** the ordering scheme according to the golden ratio is used for data acquisition.

5. Method according to any one of claims 1 to 3, **characterized in that** a quasi-random ordering scheme is used for data acquisition, in particular a Halton sequence, a van der Corput sequence or a Faure sequence is used.

## Revendications

1. Procédé de fonctionnement d'un appareil de mesure de débit magnétique nucléaire pour déterminer le débit d'un milieu, s'écoulant à travers un tube de mesure avec un écoulement à bouchon et ayant une salinité faible ou nulle, à l'aide d'un dispositif de mesure,
le dispositif de mesure comprenant un circuit RF pourvu d'une électronique externe et d'au moins une bobine RF conçue pour générer des signaux d'excitation du milieu et/ou pour détecter des signaux de mesure émis par le milieu,
une zone de bouchon de l'écoulement à bouchon étant **caractérisée par** un bouchon de milieu liquide et le milieu liquide remplissant toute la section transversale du tube de mesure et une zone de film de l'écoulement à bouchon comprenant une grosse bulle de gaz qui occupe une partie dominante de la section transversale du tube de mesure et un film liquide qui remplit la section transversale restante du tube de mesure,
des paramètres « tuning » et des paramètres « matching » étant réglés pour une zone de bouchon ou pour une zone de film, la fréquence du circuit RF pouvant être réglée par « tuning » de façon à atteindre la résonance et l'impédance de la bobine RF pouvant être adaptée à celle de l'électronique externe par « matching »,
une mesure magnétique nucléaire étant effectuée,
les amplitudes de signal mesurées étant utilisées pour déterminer s'il y a une zone de bouchon ou une zone de film dans la bobine RF, et
les amplitudes de signal étant utilisées pour déterminer le rapport eau-liquide et/ou la proportion gaz-volume dans la zone de bouchon et dans la zone de film.

2. Procédé selon la revendication 1, **caractérisé en ce qu'**une séquence CPMG ou une autre séquence d'impulsions destinées à déterminer des grandeurs magnétiques nucléaires est utilisée pour la mesure magnétique nucléaire.

3. Procédé selon la revendication 1 ou 2, **caractérisé en ce que** la mesure magnétique nucléaire est réalisée par tomographie avec stratification dans la direction z perpendiculaire à la direction d'écoulement.

4. Procédé selon l'une des revendications 1 à 3, **caractérisé en ce que** le schéma d'ordre selon le nombre d'or est utilisé pour l'acquisition de données.

5. Procédé selon l'une des revendications 1 à 3, **caractérisé en ce qu'**un schéma d'ordre basé sur la quasi-randomisation est utilisé pour l'acquisition de données, en particulier une séquence de Halton, une séquence de van der Corput ou une séquence de Faure est utilisée.
